# FASCICULE DE BREVET EUROPEEN

(11) **EP 3 465 787 B1**
(45) Date de publication et mention de la délivrance du brevet: **18.03.2020**
(21) Numéro de dépôt: 17732503.2
(22) Date de dépôt: 24.05.2017
(51) Int. Cl.: H01L 41/312, H03H 3/02, H03H 3/08

(54) **PROCEDE DE GUERISON DE DEFAUTS DANS UNE COUCHE OBTENUE PAR IMPLANTATION PUIS DETACHEMENT D'UN SUBSTRAT**
VERFAHREN ZUR REPARATUR VON DEFEKTEN IN EINER SCHICHT DURCH IMPLANTATION UND DANN ABLÖSUNG VON EINEM SUBSTRAT
METHOD FOR HEALING DEFECTS IN A LAYER OBTAINED BY IMPLANTATION THEN DETACHMENT FROM A SUBSTRATE

(30) Priorité: 25.05.2016 FR 1654673
(43) Date de publication de la demande: 10.04.2019
(73) Titulaire: Soitec, 38190 Bernin (FR)
(72) Inventeur: GHYSELEN, Bruno, 38170 Seyssinet-Pariset (FR)
(74) Mandataire: Regimbeau
(86) Numéro de dépôt international: PCT/FR2017/051290
(87) Numéro de publication internationale: WO 2017/203173

(56) Documents cités:
- EP-A2- 2 182 562
- DE-T5-112013 006 227
- BRUGERE A ET AL: "Piezoresponse Force Microscopy study of a single-crystal LiTaO 3 thin film obtained by the Smart Cut(TM) technology", APPLICATIONS OF FERROELECTRICS (ISAF), 2010 IEEE INTERNATIONAL SYMPOSIUM ON THE, IEEE, 9 août 2010 (2010-08-09), pages 1-4, XP031914559, DOI: 10.1109/ISAF.2010.5712239 ISBN: 978-1-4244-8190-3

## Description

### DOMAINE DE L'INVENTION

La présente invention concerne un procédé de guérison de défauts dans une couche de composition ABO₃, où A est constitué d'au moins un élément parmi : Li, Na, K, H, Ca, Mg, Ba, Sr, Pb, La, Bi, Y, Dy, Gd, Tb, Ce, Pr, Nd, Sm, Eu, Ho, Zr, Sc, Ag, Tl et B est constitué d'au moins un élément parmi : Nb, Ta, Sb, Ti, Zr, Sn, Ru, Fe, V, Sc, C, Ga, Al, Si, Mn, Zr, Tl, obtenue par un procédé impliquant une implantation suivie d'un détachement d'un substrat, ainsi qu'un procédé de fabrication d'une telle couche, notamment pour une application à un dispositif microélectronique, photonique ou optique. L'invention concerne également des procédés de fabrication d'un dispositif à ondes acoustiques de volume et d'un dispositif à ondes acoustiques de surface comprenant une telle couche.

### ARRIERE PLAN DE L'INVENTION

Parmi les composants acoustiques utilisés pour le filtrage dans le domaine radiofréquence, on distingue deux catégories principales de filtres :
- d'une part, les filtres à ondes acoustiques de surface, connus sous l'acronyme SAW (du terme anglo-saxon « Surface Acoustic Wave ») ;
- d'autre part, les filtres et résonateurs à ondes acoustiques de volume, connus sous l'acronyme BAW (du terme anglo-saxon « Bulk Acoustic Wave »).

Pour une revue de ces technologies, on pourra se référer à l'article de W. Steichen et S. Ballandras, « Composants acoustiques utilisés pour le filtrage - Revue des différentes technologies », Techniques de l'Ingénieur, E2000, 2008.

Les filtres à ondes acoustiques de surface comprennent typiquement une couche piézoélectrique épaisse (c'est-à-dire d'épaisseur généralement de plusieurs centaines de µm) et deux électrodes sous la forme de deux peignes métalliques interdigités déposés sur la surface de ladite couche piézoélectrique. Un signal électrique, typiquement une variation de tension électrique, appliqué à une électrode est converti en onde élastique qui se propage à la surface de la couche piézoélectrique. La propagation de cette onde élastique est favorisée si la fréquence de l'onde correspond à la bande de fréquence du filtre. Cette onde est à nouveau convertie en signal électrique en parvenant à l'autre électrode.

Les filtres à ondes acoustiques de volume comprennent quant à eux typiquement une couche piézoélectrique mince (c'est-à-dire d'épaisseur généralement bien inférieure à 1 µm) et deux électrodes agencées sur chaque face principale de ladite couche mince. Un signal électrique, typiquement une variation de tension électrique, appliquée à une électrode est convertie en onde élastique qui se propage au travers de la couche piézoélectrique. La propagation de cette onde élastique est favorisée si la fréquence de l'onde correspond à la bande de fréquence du filtre. Cette onde est à nouveau convertie en tension électrique en parvenant à l'électrode située sur la face opposée.

Dans le cas des filtres à ondes acoustiques de surface, la couche piézoélectrique doit présenter une excellente qualité cristalline pour ne pas engendrer d'atténuation de l'onde de surface. On préférera donc ici utiliser une couche monocristalline. A l'heure actuelle, les matériaux adéquats utilisables industriellement sont le quartz, le LiNbO₃ ou le LiTaO₃. La couche piézoélectrique est obtenue par découpe d'un lingot de l'un desdits matériaux, la précision requise pour l'épaisseur de ladite couche étant peu importante dans la mesure où les ondes doivent se propager essentiellement à sa surface.

Dans le cas des filtres à ondes acoustiques de volume, la couche piézoélectrique doit présenter une épaisseur déterminée et uniforme sur l'ensemble de la couche, et ce de manière précisément contrôlée. En revanche, la qualité cristalline passant de fait au second ordre des paramètres d'importance pour les performances du filtre, des compromis sont actuellement faits en ce qui concerne la qualité cristalline et une couche polycristalline a longtemps été considérée comme acceptable. La couche piézoélectrique est donc formée par dépôt sur un substrat support (par exemple un substrat de silicium). A l'heure actuelle, les matériaux employés industriellement pour un tel dépôt sont l'AIN, le ZnO et le PZT.

Les choix de matériaux sont donc très limités dans les deux technologies.

Or, le choix d'un matériau résulte d'un compromis entre différentes propriétés du filtre, en fonction des spécifications du fabricant du filtre.

Pour offrir davantage de liberté dans le dimensionnement des filtres à ondes acoustiques de volume ou des filtres à ondes acoustiques de surface, il serait souhaitable de pouvoir utiliser davantage de matériaux que les matériaux listés plus haut. En particulier, les matériaux utilisés traditionnellement pour les filtres à ondes acoustiques de surface pourraient représenter des alternatives intéressantes pour des filtres à ondes acoustiques de volume.

Ceci impose toutefois de pouvoir obtenir des couches minces, uniformes et de bonne qualité de ces matériaux.

Une première possibilité serait d'amincir les couches épaisses découpées à partir des lingots, par des techniques de polissage et/ou de gravure. Toutefois, ces techniques entraînent une perte importante de matière et ne permettent pas d'obtenir une couche de quelques centaines de nanomètres d'épaisseur avec l'uniformité requise.

Une deuxième possibilité serait de mettre en oeuvre un transfert de couche de type Smart Cut™ en créant une zone de fragilisation dans un substrat donneur de LiNbO₃ ou de LiTaO₃ de sorte à délimiter la couche mince à transférer, en collant ladite couche à transférer sur un substrat support et en détachant le substrat donneur le long de la zone de fragilisation de sorte à transférer la couche mince sur le substrat support. Toutefois, la création de la zone de fragilisation par implantation ionique dans le substrat donneur endommage la couche transférée et détériorent ses propriétés piézoélectriques. Les procédés de guérison (notamment les recuits) connus pour le transfert de couches de silicium ne permettent pas toujours de réparer complètement la couche piézoélectrique, en raison de la structure cristalline complexe de ladite couche et des mécanismes d'endommagement qui semblent différents de ceux qui interviennent dans le silicium. Un procédé de fabrication d'une couche de composition ABO3 selon la méthode de Smart Cut est connu de EP 2 182 562 A. Les problèmes de la qualité de la structure cristalline après un étape de Smart Cut sont connus des DE 11 2013 006227 T5 et Brugere A. et al., Proceedings ISAF 2010.

### BREVE DESCRIPTION DE L'INVENTION

Un but de l'invention est donc de concevoir un procédé permettant de guérir plus efficacement les défauts liés à la mise en oeuvre du procédé Smart Cut™ dans un substrat de type ABO₃.

Conformément à l'invention, il est proposé un procédé de guérison de défauts d'une couche de composition ABO₃ où A est constitué d'au moins un élément parmi : Li, Na, K, H, Ca, Mg, Ba, Sr, Pb, La, Bi, Y, Dy, Gd, Tb, Ce, Pr, Nd, Sm, Eu, Ho, Zr, Sc, Ag, Tl et B est constitué d'au moins un élément parmi : Nb, Ta, Sb, Ti, Zr, Sn, Ru, Fe, V, Sc, C, Ga, Al, Si, Mn, Zr, Tl, ladite couche étant obtenue par un procédé de transfert de couche dans lequel on implante des espèces ioniques dans un substrat de composition ABO₃ de manière à former une zone de fragilisation délimitant ladite couche puis on détache ledit substrat le long de la zone de fragilisation pour obtenir une couche détachée du reste du substrat donneur, ledit procédé étant caractérisé en ce qu'il comprend l'exposition de ladite couche à un milieu contenant des ions d'un l'élément constituant A de sorte à faire pénétrer lesdits ions dans ladite couche transférée.

Par « substrat de composition ABO₃ », on entend un substrat entièrement constitué de ABO₃ ou comprenant au moins une couche de ce matériau et dans laquelle peut être formée, par implantation puis détachement, la couche de composition ABO₃ faisant l'objet dudit procédé de guérison des défauts.

Dans le cas où A est constitué de deux éléments ou davantage, on désigne par « élément constituant A » l'un de ces éléments. Par extension et dans un souci de concision, l'élément que le procédé de guérison permet de faire pénétrer dans la couche à guérir est désigné par « élément A » dans la suite du texte.

De manière particulièrement avantageuse, les ions de l'élément A pénètrent dans la couche par un mécanisme d'échange ionique.

Selon un mode de réalisation, lequel le milieu contenant les ions de l'élément A est un liquide et la couche est immergée dans un bain dudit liquide.

Par exemple, la couche de composition ABO₃ peut être immergée dans un bain comprenant une solution acide d'un sel comprenant l'élément A.

Selon un autre mode de réalisation, le milieu contenant les ions de l'élément A est en phase gazeuse et la couche de composition ABO₃ est exposée audit gaz.

Selon un autre mode de réalisation, le milieu contenant les ions de l'élément A est en phase solide, une couche dudit milieu étant déposée sur la couche de composition ABO₃.

De manière avantageuse, le procédé comprend au moins une étape de recuit pour favoriser la diffusion de l'élément A du milieu vers la couche de composition ABO₃.

Selon une forme d'exécution particulière, l'élément A est du lithium.

La couche peut être immergée dans un bain comprenant une solution acide d'un sel de lithium.

Les ions de lithium pénètrent avantageusement dans la couche par un mécanisme d'échange protonique inverse.

Selon une forme d'exécution de l'invention, la couche de composition ABO₃ est monocristalline.

Un autre objet concerne un procédé de fabrication d'une couche de composition ABO₃ où A est constitué d'au moins un élément parmi : Li, Na, K, H, Ca, Mg, Ba, Sr, Pb, La, Bi, Y, Dy, Gd, Tb, Ce, Pr, Nd, Sm, Eu, Ho, Zr, Sc, Ag, Tl et B est constitué d'au moins un élément parmi : Nb, Ta, Sb, Ti, Zr, Sn, Ru, Fe, V, Sc, C, Ga, Al, Si, Mn, Zr, Tl, caractérisé en ce qu'il comprend :
- la fourniture d'un substrat donneur de composition ABO₃,
- la formation d'une zone de fragilisation par implantation d'espèces ioniques dans le substrat donneur de sorte à délimiter la couche,
- le détachement du substrat donneur le long de la zone de fragilisation de sorte à obtenir la couche détachée du reste du substrat donneur, ladite couche comprenant des défauts,
- la mise en oeuvre du procédé de guérison des défauts de la couche tel que décrit ci-dessus.

De manière préférée, les espèces implantées comprennent de l'hydrogène et/ou de l'hélium.

Selon un mode de réalisation, avant l'étape de guérison, on retire une partie de l'épaisseur de la couche de composition ABO₃.

Selon un mode de réalisation, l'épaisseur de la couche est supérieure à 2 µm, de préférence supérieure à 20 µm, ladite couche étant autoportée à l'issue du détachement du substrat donneur.

Selon un autre mode de réalisation, le procédé comprend, entre l'étape de formation de la zone de fragilisation et l'étape de détachement du substrat donneur le long de ladite zone de fragilisation, l'application d'un substrat receveur sur le substrat donneur, la couche de composition ABO₃ étant à l'interface entre lesdits substrats, ladite couche (10) étant transférée sur le substrat receveur à l'issue du détachement du substrat donneur.

L'application du substrat receveur peut comprendre le dépôt dudit substrat sur le substrat donneur.

De manière alternative, l'application du substrat receveur comprend le collage dudit substrat sur le substrat donneur.

De manière avantageuse, l'épaisseur de la couche de composition ABO₃ est inférieure à 20 µm.

Eventuellement, on forme au moins une couche électriquement isolante et/ou au moins une couche électriquement conductrice à l'interface entre le substrat receveur et la couche à transférer.

L'invention concerne également un procédé de fabrication d'un dispositif à ondes acoustiques de volume, comprenant la formation d'électrodes sur deux faces principales opposées d'une couche piézoélectrique, caractérisé en ce qu'il comprend la fabrication de ladite couche piézoélectrique par un procédé tel que décrit ci-dessus.

L'invention concerne également un procédé de fabrication d'un dispositif à ondes acoustiques de surface, comprenant la formation de deux électrodes interdigitées sur la surface d'une couche piézoélectrique, caractérisé en ce qu'il comprend la fabrication de ladite couche piézoélectrique par un procédé tel que décrit ci-dessus.

### BREVE DESCRIPTION DES DESSINS

D'autres caractéristiques et avantages de l'invention ressortiront de la description détaillée qui va suivre, en référence aux dessins annexés sur lesquels :
- les figures 1A à 1E illustrent de manière schématique des étapes du procédé de fabrication d'une couche monocristalline de composition ABO₃ selon un mode de réalisation de l'invention,
- la figure 2 est une vue de principe en coupe d'un filtre à ondes acoustiques de surface,
- la figure 3 est une vue de principe en coupe d'un filtre à ondes acoustiques de volume.

Pour des raisons de lisibilité des figures, les éléments illustrés ne sont pas nécessairement représentés à l'échelle. Par ailleurs, les éléments désignés par les mêmes signes de référence sur différentes figures sont identiques.

### DESCRIPTION DETAILLEE DE MODES DE REALISATION DE L'INVENTION

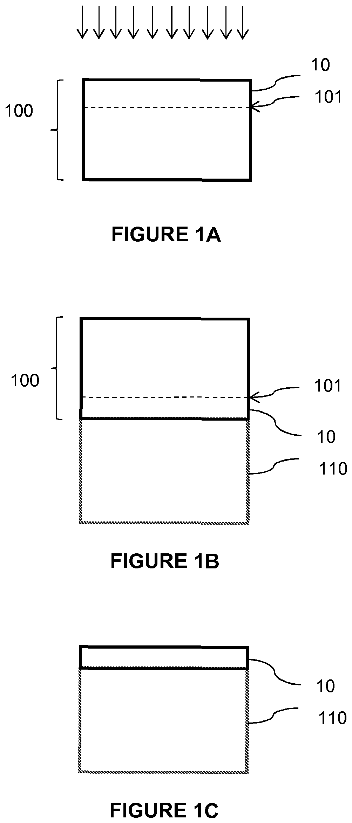

En référence aux figures 1A à 1D, on considère un procédé de fabrication d'une couche de composition ABO₃ mettant en oeuvre le procédé Smart Cut™, comprenant les étapes suivantes :
- la fourniture d'un substrat donneur de composition ABO₃,
- la formation d'une zone de fragilisation 101 par implantation d'espèces ioniques (par exemple de l'hydrogène et/ou de l'hélium) dans le substrat donneur 100 de sorte à délimiter la couche 10 à transférer (cf. figure 1A),
- l'application d'un substrat receveur 110 sur le substrat donneur 100, la couche 10 à transférer étant à l'interface (cf. figure 1B),
- le détachement du substrat donneur 100 le long de la zone de fragilisation 101 de sorte à transférer la couche 10 sur le substrat receveur 110 (cf. figure 1C).

Le substrat donneur peut être un substrat massif du matériau considéré. De manière alternative, le substrat donneur peut être un substrat composite, c'est-à-dire formé d'un empilement d'au moins deux couches de matériaux différents, dont une couche superficielle est constituée du matériau monocristallin considéré.

Parmi les matériaux piézoélectriques d'intérêt particulier se trouvent les matériaux perovskites et assimilés, de structure ABO₃. Toutefois, l'intérêt que l'on peut porter à ces matériaux ne se limite pas à leur caractère piézoélectrique. Notamment pour d'autres applications, par exemple liées à l'optique intégrée, on pourra aussi s'y intéresser le cas échéant pour leur permittivité diélectrique, pour leurs indices de réfraction, ou encore pour leurs propriétés pyroélectriques, ferroélectriques ou encore ferromagnétiques par exemple et selon les cas.

Quelques grandes familles se dégagent. L'une d'entre elles dérive notamment des matériaux binaires comme LiNbO₃, LiTaO₃, KNbO₃, KTaO₃ pour aboutir à une formule générale de type ABO₃ où A est constitué d'un ou plusieurs des éléments suivants : Li, Na, K, H et où B est constitué d'un ou plusieurs des éléments suivants : Nb, Ta, Sb, V. Une autre grande famille dérive des matériaux SrTiO₃, CaTiO₃, SrTiO₃, PbTiO₃, PbZrO₃ notamment pour aboutir à une formule générale de type ABO₃ où A est constitué d'un ou plusieurs des éléments suivants : Ba, Ca, Sr, Mg, Pb, La, Y et où B est constitué d'un ou plusieurs des éléments suivants : Ti, Zr, Sn. D'autres familles moins répandues peuvent également se décliner à partir de BiFeO₃, ou encore LaMnO₃, BaMnO₃, SrMnO₃, ou encore LaAlO3, ou encore, LiAlO₃, LiGaO₃, ou encore CaSiO₃, FeSiO₃, MgSiO₃, ou encore DyScO₃, GdScO₃ et TbScO₃.

Au final, on pourra résumer en considérant que A est constitué d'un ou plusieurs des éléments suivants parmi : Li, Na, K, H, Ca, Mg, Ba, Sr, Pb, La, Bi, Y, Dy, Gd, Tb, Ce, Pr, Nd, Sm, Eu, Ho, Zr, Sc, Ag, Tl et B est constitué d'un ou plusieurs des éléments suivants parmi : Nb, Ta, Sb, Ti, Zr, Sn, Ru, Fe, V, Sc, C, Ga, Al, Si, Mn, Zr, Tl.

Certains de ces matériaux sont monocristallins ; d'autres ne sont pas monocristallins.

La nature cristalline et la composition du substrat donneur sont choisies par l'homme du métier selon l'usage prévu pour la couche à transférer.

Le substrat receveur a une fonction de support mécanique de la couche transférée. Il peut être de toute nature et, de manière avantageuse mais non impérative, adaptée à l'application visée, la couche transférée pouvant éventuellement être reportée ultérieurement sur un autre substrat. Le substrat receveur peut être massif ou composite.

Selon un mode de réalisation, l'application du substrat receveur sur le substrat donneur est réalisée par collage.

De manière alternative, l'application du substrat receveur sur le substrat donneur est réalisée par un dépôt du substrat receveur sur le substrat donneur. Toute technique de dépôt adaptée, telle que, par exemple mais de manière non limitative, une évaporation, une pulvérisation cathodique, une pulvérisation aérosol, un dépôt en phase chimique, une électrodéposition, une enduction, un dépôt par centrifugation, un vernissage, une sérigraphie, une immersion, peut être utilisée. Une telle solution est particulièrement avantageuse pour pallier une mauvaise adhésion du substrat donneur vis-à-vis du substrat receveur.

Eventuellement, le procédé comprend la formation d'au moins une couche électriquement isolante et/ou au moins une couche électriquement conductrice (non représentée) à l'interface entre le substrat receveur 110 et la couche 10 à transférer.

Dans le cas où la couche 10 est suffisamment épaisse pour lui conférer une certaine tenue mécanique, notamment lors de l'opération de détachement le long de la zone de fragilisation, l'étape d'application du substrat receveur peut être omise. La couche 10 est alors dite autoportée après son détachement du reste du substrat donneur. Dans ce cas, l'épaisseur de la couche 10 est typiquement supérieure à 2 µm, de préférence supérieure à 20 µm, et l'énergie d'implantation des espèces ioniques est supérieure à 1 MeV.

On prend pour exemple dans la suite du texte une couche transférée de composition LiXO₃, où X est du niobium et/ou du tantale. En d'autres termes, dans cet exemple non limitatif, l'élément A est du lithium et l'élément B est du niobium et/ou du tantale, étant entendu que l'homme du métier est à même de définir les conditions adéquates pour les autres matériaux cités plus haut. Notamment, la guérison de la couche 10 fait intervenir un mécanisme d'échange ionique qui est utilisé dans le domaine des verres. Par exemple, il est connu de remplacer une partie des ions Na+ présents dans certains verres par des ions Ag+ ou K+, en mettant en oeuvre un traitement consistant à immerger le verre dans un bain de sels fondus par exemple d'AgNO₃ ou de KNO₃, respectivement. De manière similaire, l'invention peut être mise en oeuvre en exposant la couche à guérir à un milieu contenant des ions de l'élément A dont on souhaite enrichir ladite couche, ledit milieu pouvant être liquide (par exemple un bain d'une solution acide d'un sel comprenant l'élément A), gazeux ou solide.

Lors du procédé de transfert de la couche 10 du substrat donneur au substrat receveur, notamment lors de l'implantation des espèces ioniques et/ou des traitements thermiques de renforcement du collage ou de détachement, du lithium peut être amené à migrer hors de ladite couche 10.

Cette migration du lithium peut éventuellement s'accompagner d'un remplacement des atomes concernés par des atomes d'hydrogène implantés pour former la zone de fragilisation.

La couche transférée 10 est donc défectueuse du fait de cette déficience en lithium.

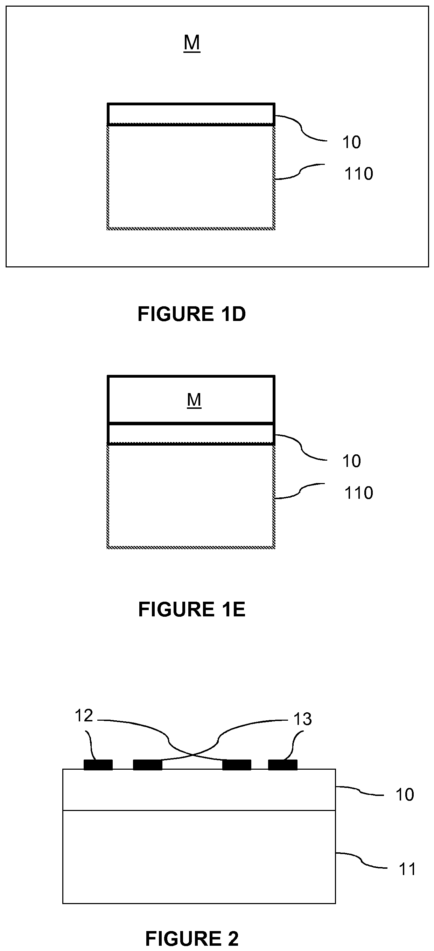

Pour y remédier, l'invention propose un procédé de guérison des défauts de la couche transférée, dans lequel on expose la couche transférée (et éventuellement l'ensemble du substrat receveur qui la supporte) à un milieu M contenant des ions lithium (cf. figure 1D).

Cette exposition a pour effet de faire migrer des ions lithium du milieu M vers la couche transférée 10, enrichissant ainsi la couche transférée en lithium et restaurant la structure de ladite couche préalablement à l'implantation et au transfert.

Eventuellement, des atomes d'hydrogène situés à l'emplacement d'atomes de lithium peuvent migrer vers le milieu M.

Un mécanisme du type échange protonique inverse est mis en jeu dans cette migration.

L'échange protonique inverse est décrit, en lien avec une toute autre application que celle adressée par la présente invention, dans l'article de Yu. N. Korkishko et al intitulé « Reverse proton exchange for buried waveguides in LiNbO3 », J. Opt. Soc. Am. A, Vol. 15, No. 7, July 1998.

Le milieu M peut être un liquide, auquel cas la couche transférée est immergée dans un bain dudit liquide. Par exemple, dans le présent exemple, le milieu M est une solution acide d'un sel de lithium. L'homme du métier sait également utiliser des mélanges de solutions de LiNO₃, de KNO₃ et de NaNO₃ pour mieux contrôler l'efficacité de cette opération.

De manière alternative, le milieu M peut être gazeux, auquel cas la couche transférée est placée dans une enceinte contenant ledit gaz.

L'homme du métier est à même de définir les conditions opératoires de cette exposition, notamment la composition du milieu, la durée et la température d'exposition, en fonction de la composition de la couche transférée à guérir.

De manière avantageuse, l'épaisseur de la couche transférée est inférieure à 20 µm, de préférence inférieure à 2 µm.

Selon une autre alternative, le milieu M peut être en phase solide, et la couche transférée 10 est exposée audit milieu par dépôt d'une couche dudit milieu sur la couche 10 (cf. figure 1E). Par « sur » on entend ici soit directement en contact avec ladite couche 10, soit par l'intermédiaire d'une ou plusieurs couches formées de matériaux différents, dans la mesure où lesdites couches intermédiaires ne bloquent pas la migration de l'élément A de la couche constituant le milieu M vers la couche 10.

Une meilleure pénétration des ions de l'élément A dans la couche 10 est rendue possible par une ou plusieurs étapes de recuit. La couche déposée contenant l'élément A peut être retirée à la fin de l'opération, éventuellement entre deux étapes de recuits successives.

Eventuellement, avant l'étape de guérison, on retire une partie de l'épaisseur de la couche transférée sur le substrat receveur. Ce retrait peut être réalisé par polissage mécano-chimique, par gravure ou par toute autre technique appropriée.

On décrit ci-après deux applications non limitatives de la couche 10 transférée et guérie selon l'invention.

La figure 2 est une vue de principe d'un filtre à ondes acoustiques de surface.

Ledit filtre comprend une couche piézoélectrique 10 et deux électrodes 12, 13 sous la forme de deux peignes métalliques interdigités déposés sur la surface de ladite couche piézoélectrique. Du côté opposé aux électrodes 12, 13, la couche piézoélectrique repose sur un substrat support 11. La couche piézoélectrique 10 est monocristalline, une excellente qualité cristalline étant en effet nécessaire pour ne pas engendrer d'atténuation de l'onde de surface.

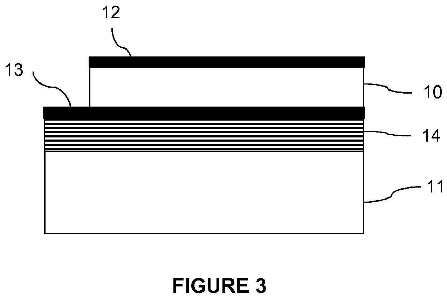

La figure 3 est une vue de principe d'un résonateur à ondes acoustiques de volume.

Le résonateur comprend une couche piézoélectrique mince (c'est-à-dire d'épaisseur généralement inférieure à 1 µm, de préférence inférieure à 0,2 µm) et deux électrodes 12, 13 agencées de part et d'autre de ladite couche piézoélectrique 10. La couche piézoélectrique 10 repose sur un substrat support 11. Pour isoler le résonateur du substrat et éviter ainsi la propagation des ondes dans le substrat, un miroir de Bragg 14 est interposé entre l'électrode 13 et le substrat 11. De manière alternative (non illustrée), cette isolation pourrait être réalisée en ménageant une cavité entre le substrat et la couche piézoélectrique. Ces différentes dispositions sont connues de l'homme du métier et ne seront donc pas décrites en détail dans le présent texte.

Dans certains cas, le substrat receveur peut ne pas être optimal pour l'application finale. Il peut alors être avantageux de transférer la couche 10 sur un substrat final (non représenté) dont les propriétés sont choisies en fonction de l'application visée, en la collant sur ledit substrat final et en retirant le substrat receveur par toute technique adaptée.

Dans le cas où l'on souhaite fabriquer un dispositif à ondes acoustiques de surface, on dépose, sur la surface de la couche 10 opposée au substrat receveur 110 ou, le cas échéant, au substrat final (qu'il s'agisse du substrat receveur 110 ou du substrat final 111, ledit substrat forme le substrat support noté 11 sur la figure 2), des électrodes métalliques 12, 13 sous la forme de deux peignes interdigités.

Dans le cas où l'on souhaite fabriquer un dispositif à ondes acoustiques de volume, une adaptation du procédé décrit ci-dessus doit être effectuée. D'une part, on dépose, avant l'étape de collage illustrée sur la figure 1B, une première électrode sur la surface libre de la couche 10 à transférer du substrat donneur, cette première électrode (référencée 13 sur la figure 3) se trouvant enterrée dans l'empilement final. Après l'étape de transfert illustrée sur la figure 1C, on dépose une seconde électrode (référencée 12 sur la figure 3) sur la surface libre de la couche 10, opposée à la première électrode. Une autre option est de transférer la couche 10 sur un substrat final comme mentionné plus haut et de former les électrodes avant et après ledit transfert. D'autre part, pour éviter la propagation des ondes acoustiques dans le substrat receveur 110, on peut intégrer à celui-ci un moyen d'isolation pouvant être, par exemple, un miroir de Bragg (comme illustré sur la figure 3) ou une cavité préalablement gravée dans le substrat receveur ou dans le substrat final le cas échéant.

Enfin, il va de soi que les exemples que l'on vient de donner ne sont que des illustrations particulières en aucun cas limitatives quant aux domaines d'application de l'invention.

### REFERENCES

W. Steichen et S. Ballandras, Composants acoustiques utilisés pour le filtrage - Revue des différentes technologies, Techniques de l'Ingénieur, E2000, 2008
Yu. N. Korkishko et al, Reverse proton exchange for buried waveguides in LiNbO3, J. Opt. Soc. Am. A, Vol. 15, No. 7, July 1998

## Revendications

1. Procédé de guérison de défauts d'une couche (10) de composition ABO₃ où A est constitué d'au moins un élément parmi : Li, Na, K, H, Ca, Mg, Ba, Sr, Pb, La, Bi, Y, Dy, Gd, Tb, Ce, Pr, Nd, Sm, Eu, Ho, Zr, Sc, Ag, Tl et B est constitué d'au moins un élément parmi : Nb, Ta, Sb, Ti, Zr, Sn, Ru, Fe, V, Sc, C, Ga, Al, Si, Mn, Zr, Tl, ladite couche (10) étant obtenue par un procédé de transfert de couche dans lequel on implante des espèces ioniques dans un substrat (100) de composition ABO₃ de manière à former une zone de fragilisation délimitant ladite couche puis on détache ledit substrat le long de la zone de fragilisation pour obtenir une couche (10) détachée du reste du substrat donneur, **caractérisé en ce qu'**il comprend l'exposition de ladite couche (10) à un milieu (M) contenant des ions d'un élément constituant A de sorte à faire pénétrer lesdits ions dans ladite couche transférée.

2. Procédé selon la revendication 1, dans lequel lesdits ions pénètrent dans la couche (10) par un mécanisme d'échange ionique.

3. Procédé selon l'une des revendications 1 ou 2, dans lequel le milieu (M) contenant les ions est un liquide et la couche (10) est immergée dans un bain dudit liquide.

4. Procédé selon l'une des revendications 1 à 3, dans lequel la couche (10) de composition ABO₃ est immergée dans un bain comprenant une solution acide d'un sel comprenant ledit élément constituant A.

5. Procédé selon l'une des revendications 1 ou 2, dans lequel le milieu (M) contenant les ions est en phase gazeuse et la couche (10) est exposée audit gaz.

6. Procédé selon l'une des revendications 1 ou 2, dans lequel le milieu (M) contenant les ions est en phase solide, une couche dudit milieu (M) étant déposée sur la couche (10).

7. Procédé selon la revendication 6, comprenant au moins une étape de recuit pour favoriser la diffusion de l'élément constituant A du milieu (M) vers la couche (10).

8. Procédé selon l'une des revendications 1 à 7, dans lequel A est du lithium.

9. Procédé selon la revendication 8, dans lequel les ions de lithium pénètrent dans la couche (10) par un mécanisme d'échange protonique inverse.

10. Procédé selon l'une des revendications 8 ou 9, dans lequel la couche (10) est immergée dans un bain comprenant une solution acide d'un sel de lithium.

11. Procédé selon l'une des revendications 1 à 10, dans lequel la couche (10) est monocristalline.

12. Procédé de de fabrication d'une couche (10) de composition ABO₃ où A est constitué d'au moins un élément parmi : Li, Na, K, H, Ca, Mg, Ba, Sr, Pb, La, Bi, Y, Dy, Gd, Tb, Ce, Pr, Nd, Sm, Eu, Ho, Zr, Sc, Ag, Tl et B est constitué d'au moins un élément parmi : Nb, Ta, Sb, Ti, Zr, Sn, Ru, Fe, V, Sc, C, Ga, Al, Si, Mn, Zr, Tl, **caractérisé en ce qu'**il comprend :
- la fourniture d'un substrat donneur (100) de composition ABO₃,
- la formation d'une zone de fragilisation (101) par implantation d'espèces ioniques dans le substrat donneur (100) de sorte à délimiter la couche (10),
- le détachement du substrat donneur (100) le long de la zone de fragilisation (101) de sorte à obtenir la couche (10) détachée du reste du substrat donneur (100), ladite couche comprenant des défauts,
- la mise en oeuvre du procédé de guérison des défauts de la couche (10) selon l'une des revendications 1 à 11.

13. Procédé selon la revendication 12, dans lequel les espèces implantées comprennent de l'hydrogène et/ou de l'hélium.

14. Procédé selon l'une des revendications 12 ou 13, dans lequel, avant l'étape de guérison, on retire une partie de l'épaisseur de la couche (10).

15. Procédé selon l'une des revendications 12 à 14, dans lequel l'épaisseur de la couche (10) est supérieure à 2 µm, de préférence supérieure à 20 µm, ladite couche étant autoportée à l'issue du détachement du substrat donneur (100).

16. Procédé selon l'une des revendications 12 à 14, comprenant, entre l'étape de formation de la zone de fragilisation et l'étape de détachement du substrat donneur le long de ladite zone de fragilisation, l'application d'un substrat receveur (110) sur le substrat donneur (100), la couche (10) étant à l'interface entre lesdits substrats (100, 110), ladite couche (10) étant transférée sur le substrat receveur (110) à l'issue du détachement du substrat donneur (100).

17. Procédé selon la revendication 16, dans lequel l'application du substrat receveur comprend le dépôt dudit substrat (110) sur le substrat donneur (100).

18. Procédé selon la revendication 16, dans lequel l'application du substrat receveur comprend le collage dudit substrat (110) sur le substrat donneur (100).

19. Procédé selon l'une des revendications 16 à 18, dans lequel l'épaisseur de la couche (10) est inférieure à 20 µm.

20. Procédé selon l'une des revendications 16 à 19, dans lequel on forme au moins une couche électriquement isolante et/ou au moins une couche électriquement conductrice à l'interface entre le substrat receveur (110) et la couche (10) à transférer.

21. Procédé de fabrication d'un dispositif à ondes acoustiques de volume, comprenant la formation d'électrodes (12, 13) sur deux faces principales opposées d'une couche piézoélectrique (10), **caractérisé en ce qu'**il comprend la fabrication de ladite couche piézoélectrique (10) par un procédé selon l'une des revendications 12 à 20.

22. Procédé de fabrication d'un dispositif à ondes acoustiques de surface, comprenant la formation de deux électrodes (12, 13) interdigitées sur la surface d'une couche piézoélectrique (10), **caractérisé en ce qu'**il comprend la fabrication de ladite couche piézoélectrique par un procédé selon l'une des revendications 12 à 20.

## Patentansprüche

1. Heilungsverfahren von Fehlern einer Schicht (10) mit der Zusammensatzung ABO₃, in der A aus wenigstens einem Element gebildet ist aus: Li, Na, K, H, Ca, Mg, Ba, Sr, Pb, La, Bi, Y, Dy, Gd, Tb, Ce, Pr, Nd, Sm, Eu, Ho, Zr, Sc, Ag, TI und B aus wenigstens einem Element gebildet ist aus: Nb, Ta, Sb, Ti, Zr, Sn, Ru, Fe, V, Sc, C, Ga, Al, Si, Mn, Zr, TI, wobei die genannte Schicht (10) durch ein Schichtübertragungsverfahren erhalten wird, in der ionische Arten in ein Substrat (100) mit der Zusammensetzung ABO₃ derart implantiert werden, dass ein Schwächungsbereich geformt wird, der die genannte Schicht begrenzt, dann wird das genannte Substrat entlang dem Schwächungsbereich abgelöst, um eine Schicht (10) zu erhalten, die von dem Rest des Spendersubstrats abgelöst ist, **dadurch gekennzeichnet, dass** sie das Kontaktieren der genannten Schicht (10) mit einem Milieu (M) umfasst, das Ionen einen Bestanteils A derart enthält, dass die genannten Ionen in die genannte übertragene Schicht zum Eindringen gebracht werden.

2. Verfahren gemäß Anspruch 1, bei dem die genannten Ionen in die Schicht (10) durch einen Ionenaustausch-Mechanismus eindringen.

3. Verfahren gemäß einem der Ansprüche 1 oder 2, bei dem das Milieu (M), das die Ionen enthält, eine Flüssigkeit ist und die Schicht (10) in ein Bad der genannten Flüssigkeit eingetaucht ist.

4. Verfahren gemäß einem der Ansprüche 1 bis 3, bei dem die Schicht (10) mit der Zusammensetzung ABO₃ in ein Bad eingetaucht ist, das eine saure Lösung eines Salzes umfasst, das den genannten Bestandteil A umfasst.

5. Verfahren gemäß einem der Ansprüche 1 oder 2, bei dem das Milieu (M), das die Ionen enthält, in der gashaltigen Phase ist und die Schicht (10) mit dem genannten Gas in Kontakt ist.

6. Verfahren gemäß einem der Ansprüche 1 oder 2, bei dem das Milieu (M), das die Ionen enthält, in der festen Phase ist und wobei eine Schicht des genannten Milieus (M) auf der Schicht (10) aufgebracht ist.

7. Verfahren gemäß Anspruch 6, umfassend wenigstens einen Temperschritt zum Begünstigen der Verbreitung des Bestandteils A des Milieus (M) zur Schicht (10).

8. Verfahren gemäß einem der Ansprüche 1 bis 7, bei dem A Lithium ist.

9. Verfahren gemäß Anspruch 8, bei dem die Lithiumionen durch einen umgekehrten Protonenaustausch-Mechanismus in die Schicht (10) eindringen.

10. Verfahren gemäß einem der Ansprüche 8 oder 9, bei dem die Schicht (10) in ein Bad getaucht ist, das eine saure Lösung eines Lithiumsalzes umfasst.

11. Verfahren gemäß einem der Ansprüche 1 bis 10, bei dem die Schicht (10) monokristallin ist.

12. Herstellungsverfahren einer Schicht (10) mit einer Zusammensetzung ABO₃, in der A aus wenigstens einem der Elemente gebildet ist aus: Li, Na, K, H, Ca, Mg, Ba, Sr, Pb, La, Bi, Y, Dy, Gd, Tb, Ce, Pr, Nd, Sm, Eu, Ho, Zr, Sc, Ag, TI und B aus wenigstens einem Element gebildet ist aus: Nb, Ta, Sb, Ti, Zr, Sn, Ru, Fe, V, Sc, C, Ga, Al, Si, Mn, Zr, TI, **dadurch gekennzeichnet, dass** es umfasst:
- die Lieferung eines Spendersubstrats (100) mit der Zusammensetzung ABO₃,
- die Bildung eines Schwächungsbereichs (101) per Implantieren von ionischen Arten in das Spendersubstrat (100) derart, dass die Schicht (10) begrenzt wird,
- das Ablösen des Spendersubstrats (100) entlang dem Schwächungsbereich (101) derart, dass die Schicht (10) erhalten wird, die vom Rest des Spendersubstrats (100) abgelöst ist, wobei die genannte Schicht Fehler umfasst,
- das Umsetzen des Heilungsverfahrens der Fehler der Schicht (10) gemäß einem der Ansprüche 1 bis 11.

13. Verfahren gemäß Anspruch 12, bei dem die implantierten Arten Wasserstoff und / oder Helium umfassen.

14. Verfahren gemäß einem der Ansprüche 12 oder 13, bei dem vor dem Heilungsschritt ein Teil der Dicke der Schicht (10) entfernt wird.

15. Verfahren gemäß einem der Ansprüche 12 bis 14, bei dem die Dicke der Schicht (10) größer ist als 2 µm, bevorzugt größer als 20 µm, wobei die genannte Schicht nach dem Ablösen des Spendersubstrats (100) selbstgetragen ist.

16. Verfahren gemäß einem der Ansprüche 12 bis 14, umfassend zwischen dem Bildungsschritt des Schwächungsbereichs und dem Ablöseschritt des Spendersubstrats entlang dem Schwächungsbereich die Anwendung eines Empfängersubstrats (110) auf dem Spendersubstrat (100), wobei die Schicht (100) an der Schnittstelle zwischen den genannten Substraten (100, 110) ist, wobei die genannte Schicht (10) nach dem Ablösen des Spendersubstrats (100) auf das Empfängersubstrat (110) übertragen wird.

17. Verfahren gemäß Anspruch 16, bei dem die Anwendung des Empfängersubstrats das Aufbringen des genannten Substrats (110) auf das Spendersubstrat (100) umfasst.

18. Verfahren gemäß Anspruch 16, bei dem die Anwendung des Empfängersubstrats das Verkleben des genannten Substrats (110) auf dem Spendersubstrat (100) umfasst.

19. Verfahren gemäß einem der Ansprüche 16 bis 18, bei dem die Dicke der Schicht (10) geringer ist als 20 µm.

20. Verfahren gemäß einem der Ansprüche 16 bis 19, bei dem wenigstens eine elektrisch isolierende Schicht und / oder wenigstens eine elektrisch leitende Schicht an der Schnittstelle zwischen dem Empfängersubstrat (110) und der zu übertragenden Schicht (10) geformt wird.

21. Herstellungsverfahren einer Vorrichtung mit akustischen Volumenwellen, umfassend die Bildung von Elektroden (12, 13) auf zwei Hauptseiten gegenüber einer piezoelektrischen Schicht (10), **dadurch gekennzeichnet, dass** sie die Herstellung der genannten piezoelektrischen Schicht (10) durch ein Verfahren gemäß einem der Ansprüche 12 bis 20 umfasst.

22. Herstellungsverfahren einer Vorrichtung mit akustischen Oberflächenwellen, umfassend das Bilden von zwei Elektroden (12, 13), die auf der Oberfläche einer piezoelektrischen Schicht (10) versetzt angeordnet sind, **dadurch gekennzeichnet, dass** es die Herstellung der genannten piezoelektrischen Schicht durch ein Verfahren gemäß einem der Ansprüche 12 bis 20 umfasst.

## Claims

1. Method for healing defects in a layer (10) of composition ABO₃ where A consists of at least one element selected from: Li, Na, K, H, Ca, Mg, Ba, Sr, Pb, La, Bi, Y, Dy, Gd, Tb, Ce, Pr, Nd, Sm, Eu, Ho, Zr, Sc, Ag, Tl and B consists of at least one element selected from: Nb, Ta, Sb, Ti, Zr, Sn, Ru, Fe, V, Sc, C, Ga, Al, Si, Mn, Zr, Tl, said layer (10) being obtained by a layer transfer method in which ionic species are implanted into a substrate (100) of composition ABO₃ so as to form a weakened zone delineating said layer, said substrate then being detached along the weakened zone in order to obtain a layer (10) detached from the rest of the donor substrate, **characterised in that** it comprises exposing said layer (10) to a medium (M) containing ions of a constituent element A so as to make said ions penetrate into said transferred layer.

2. Method according to claim 1, in which said ions penetrate into the layer (10) by an ion exchange mechanism.

3. Method according to one of claims 1 or 2, in which the medium (M) containing the ions is a liquid and the layer (10) is immersed in a bath of said liquid.

4. Method according to one of claims 1 to 3, in which the layer (10) of composition ABO₃ is immersed in a bath comprising an acid solution of a salt comprising said constituent element A.

5. Method according to one of claims 1 or 2, in which the medium (M) containing the ions is in gaseous phase and the layer (10) is exposed to said gas.

6. Method according to one of claims 1 or 2, in which the medium (M) containing the ions is in solid phase, a layer of said medium (M) being deposited on the layer (10).

7. Method according to claim 6, comprising at least one annealing step to favour the diffusion of the constituent element A from the medium (M) to the layer (10) .

8. Method according to one of claims 1 to 7, in which A is lithium.

9. Method according to claim 8, in which the lithium ions penetrate into the layer (10) by a reverse proton exchange mechanism.

10. Method according to one of claims 8 or 9, in which the layer (10) is immersed in a bath comprising an acid solution of a lithium salt.

11. Method according to one of claims 1 to 10, in which the layer (10) is monocrystalline.

12. Method for producing a layer (10) of composition ABO₃ where A consists of at least one element selected from: Li, Na, K, H, Ca, Mg, Ba, Sr, Pb, La, Bi, Y, Dy, Gd, Tb, Ce, Pr, Nd, Sm, Eu, Ho, Zr, Sc, Ag, Tl and B consists of at least one element selected from: Nb, Ta, Sb, Ti, Zr, Sn, Ru, Fe, V, Sc, C, Ga, Al, Si, Mn, Zr, Tl, **characterised in that** it comprises:
- providing a donor substrate (100) of composition ABO₃,
- forming a weakened zone (101) by implantation of ionic species in the donor substrate (100) so as to delineate the layer (10),
- detaching the donor substrate (100) along the weakened zone (101) so as to obtain the layer (10) detached from the rest of the donor substrate (100), said layer comprising defects,
- implementing the method for healings defects of the layer (10) according to one of claims 1 to 11.

13. Method according to claim 12, in which the implanted species comprises hydrogen and/or helium.

14. Method according to one of claims 12 or 13, in which, before the healing step, a part of the thickness of the layer (10) is removed.

15. Method according to one of claims 12 to 14, in which the thickness of the layer (10) is greater than 2 µm, preferably greater than 20 µm, said layer being self-supporting at the end of the detachment from the donor substrate (100).

16. Method according to one of claims 12 to 14, comprising, between the step of formation of the weakened zone and the step of detachment from the donor substrate along said weakened zone, the application of a receiver substrate (110) on the donor substrate (100), the layer (10) being at the interface between said substrates (100, 110), said layer (10) being transferred onto the receiver substrate (110) at the end of the detachment from the donor substrate (100).

17. Method according to claim 16, in which the application of the receiver substrate comprises the deposition of said substrate (110) on the donor substrate (100).

18. Method according to claim 16, in which the application of the receiver substrate comprises the bonding of said substrate (110) on the donor substrate (100) .

19. Method according to one of claims 16 to 18, in which the thickness of the layer (10) is less than 20 µm.

20. Method according to one of claims 16 to 19, in which at least one electrically insulating layer and/or at least one electrically conducting layer is formed at the interface between the receiver substrate (110) and the layer (10) to transfer.

21. Method for producing a bulk acoustic wave device, comprising the formation of electrodes (12, 13) on two opposite main faces of a piezoelectric layer (10), **characterised in that** it comprises the production of said piezoelectric layer (10) by a method according to one of claims 12 to 20.

22. Method for producing a surface acoustic wave device, comprising the formation of two interdigitated electrodes (12, 13) on the surface of a piezoelectric layer (10), **characterised in that** it comprises the production of said piezoelectric layer by a method according to one of claims 12 to 20.
